# EUROPÄISCHE PATENTSCHRIFT

(11) **EP 0 538 611 B1**
(45) Veröffentlichungstag und Bekanntmachung des Hinweises auf die Patenterteilung: **13.03.1996**
(21) Anmeldenummer: 92115370.6
(22) Anmeldetag: 09.09.1992
(51) Int. Cl.: C30B 25/02, C30B 23/02, C30B 29/36

(54) **Mehrschichtige Zusammensetzung mit einer Schicht aus monokirstallinem Beta-Siliziumkarbid**
Multilayered composition with a single crystal beta-silicon carbide layer
Composition multi-couche comportant une couche monocristalline de carbure de silicium bêta

(30) Priorität: 24.10.1991 DE 4135076
(43) Veröffentlichungstag der Anmeldung: 28.04.1993
(73) Patentinhaber: Daimler-Benz Aktiengesellschaft, D-70546 Stuttgart (DE)
(72) Erfinder: Niemann, Ekkehard, W-6457 Maintal 4 (DE); Grueninger, Hans Wolfgang, Dr., W-6239 Kriftel (DE); Leidich, Dieter, W-6239 Kriftel (DE)
(74) Vertreter: Vogl, Leo, Dipl.-Ing.

(56) Entgegenhaltungen:
- EP-A- 0 269 439
- EP-A- 0 322 615
- WO-A-88/04333
- DE-A- 3 415 799
- DE-A- 3 620 329
- PATENT ABSTRACTS OF JAPAN vol. 13, no. 137 (C-582)(3485) 5. April 1989
- PATENT ABSTRACTS OF JAPAN vol. 9, no. 145 (C-287)(1868) 20. Juni 1985

## Beschreibung

Die Erfindung betrifft eine mehrschichtige Zusammensetzung mit einer Schicht aus monokristallinem Beta-Siliziumkarbid, mit einer einkristallinen Substratschicht und mit einer dazwischen liegenden, eine Gitteranpassung bewirkenden, dünnen Pufferschicht

Eine derartige Zusammensetzung ist aus den PATENT ABSTRACTS OF JAPAN, vol. 13, no. 137 (C 587) (3485) vom 05.04.1989 bekannt. Auf einem einkristallinen Silizium-Substrat wird eine Pufferschicht aus Titankarbid (TiC) erzeugt. Durch Schichtabscheidung aus der Gasphase wird auf der Pufferschicht monokristallines Siliziumkarbid abgeschieden.

Aus der WO-A-8 804 333 ist es bekannt, kristallines β-Siliziumkarbid auf einem Substrat mit ähnlicher Kristallstruktur aufwachsen zu lassen. Als Beispiel ist Titankarbid (TiC) genannt.

Der Erfindung liegt die Aufgabe zugrunde, für die Herstellung von integrierten Bauelementen eine kristalline Zusammensetzung mit einer möglichst groß flächigen und möglichst fehlerfreien monokristallinen Schicht aus Siliziumkarbid zu schaffen.

Diese Aufgabe wird dadurch gelöst, daß in der Schicht aus monokristallinem Beta-Siliziumkarbid mindestens ein elektronisches Bauteil integriert ist, daß die dünne Pufferschicht weder Siliziumkarbid noch das Material der Substratschicht noch TiC enthält und daß das Material der Pufferschicht eine Gitterkonstante zwischen 4,2 ·10⁻¹⁰ m bis 4,5 · 10⁻¹⁰ m hat.

Vorteilhaft wirkt sich dabei aus, daß die Pufferschicht zwischen dem Einkristall-Substrat und dem monokristallinen Siliziumkarbid eine Gitterkonstante aufweist, die nur sehr wenig von der Gitterkonstante von Beta-Siliziumkarbid (4,3 · 10⁻¹⁰ m bis 4,4 · 10⁻¹⁰ m) abweicht; auf diese Weise wird eine Anpassung zwischen dem Einkristall-Substrat und dem Siliziumkarbid erreicht. Die Pufferschicht ("buffer layer") ermöglicht also die Gewinnung eines annähernd fehlerfreien Einkristalls aus Siliziumkarbid, in den sich elektronische Bauelemente (als laterale Bauelemente) integrieren lassen. Die Pufferschicht selbst braucht nicht unbedingt einkristallin vorzuliegen.

Die Dotierung für die elektronischen Bauelemente in der Siliziumkarbid-Schicht zur Erzeugung von n-leitenden und p-leitenden Zonen wird während der Herstellung oder - durch Ionenimplantation - nach der Herstellung vorgenommen.

Wegen des hohen Bandabstandes eignen sich Halbleiterbauelemente aus Siliziumkarbid besonders gut für die Leistungselektronik. Ausserdem können derartige Halbleiterbauelemente auch bei hohen Temperaturen (bis ca. 600°C) eingesetzt werden. SiC-Bauelemente kommen ohne Kühlkörper aus und sind deshalb in verhältnismässig kleiner und leichter Ausführung herstellbar. Sie zeichnen sich zusätzlich durch ihre hohe Beständigkeit gegen Überlastungen und hochenergetische Strahlung aus. SiC-Dioden haben einen um mehrere Größenordnungen niedrigeren Leckstrom als entsprechende Si-Dioden.

Elektronische Bauelemente mit den erwähnten Eigenschaften werden in der Automobil- oder Flugzeugindustrie, bei Ölbohrungen, im Kernkraftwerk, im Weltraum oder einfach zur Steuerung von Hochtemperatur-Kreisen benötigt. Es ist eine Weiterentwicklung zu SiC-Bauelementen zu erwarten, die sich unter extremen chemischen und physikalischen Bedingungen betreiben lassen.

Günstig für Anwendungen für hochfrequente Schaltungen ist die kurze Minoritätsträgerlebensdauer in Siliziumkarbid von ca. 10 ns; Siliziumkarbid-Dioden zeichnen sich also durch eine hohe Schaltfrequenz aus.

Zusätzlich sind Siliziumkarbid-Bauelemente (im Vergleich zu herkömmlichen Si-Bauelementen) besonders störunempfindlich gegen elektromagnetische Strahlung.

Vorteilhaft ist der Einsatz von Silizium als Substratmaterial, da Siliziumwafer verhältnismässig kostengünstig auch in großflächiger Ausführung gehandelt werden.

Weitere vorteilhafte Ausbildungen sind den übrigen Unteransprüchen zu entnehmen; eine Herstellung ist im Anspruch 11 beschrieben.

Die Erfindung wird im folgenden an Hand eines Ausführungsbeispiels, aus dem sich weitere Merkmale, Einzelheiten und Vorteile ergeben, näher beschrieben.

Ein als Einkristall-Substrat dienender Wafer aus Silizium mit einem Durchmesser von ca. 3 Zoll wird zunächst angeschliffen, und zwar in einem Winkel von ca. 4° gegenüber den zu der flachen Oberfläche parallelen Netzebenen des (einkristallinen) Wafers aus Silizium. Die Netzebenen sind diejenigen Ebenen in einem Kristallgitter (eines Einkristalls), die durch die regelmässige Anordnung der Atome in einem Kristallgitter gebildet werden und auf denen in gleichen Abständen Atome oder Ionen des Kristalls angeordnet sind. Diese Bezeichnung leitet sich von der anschaulichen Vorstellung her, dass man die Atome oder Ionen mit den regelmässig angeordneten Knoten eines Netzes vergleichen kann. Zu jeder Netzebene gibt es in einem Einkristall mehrere parallele Netzebenen.

Durch das Anschleifen wird die fehlerfreie Anlagerung von Bausteinen - zur Erzeugung einer Pufferschicht - an das kristalline Silizium begünstigt; das Anschleifen führt nämlich - bei Zugrundelegung eines Modells im atomaren Bereich - zu einem stufigen Verlauf der Kristalloberfläche. Wenn die Stufen annähernd gleich hoch sind, lagern sich die Bausteine auf allen Stufen in ungefähr der gleichen Geschwindigkeit an; dieser Anlagerungsmechanismus begünstigt ein gleichmässiges, fehlerfreies Kristallwachstum. Die seitliche Anlagerung von Bausteinen an ein Kristall wird wegen des Energiegewinns und dem damit verbundenen Übergang in einen stabileren Zustand gegenüber dem Aufbau einer neuen Ebene bevorzugt.

Die angeschliffene Oberfläche des Wafers wird gereinigt in einer Flüssigkeit mit ca. 525 ml H₂O, ca. 150 ml H₂O₂ und ca. 75 ml NH₃, wobei die Flüssigkeit eine Temperatur von 90 °C aufweist.

Die Pufferschicht kann durch reaktives Sputtern, durch Schichtabscheidung aus der Gasphase (CVD-Verfahren) oder durch Elektronenstrahl-Aufdampfen aufgetragen werden.

Beim sog. reaktiven Sputtern wird zum Aufbringen der Pufferschicht ein rein metallisches Target verwendet. Die für die Pufferschicht benötigte chemische Verbindung zwischen dem Metall (z. B. Titan) und dem Nichtmetall (z. B. Stickstoff) entsteht während des Sputtering-Vorganges nach dem Ablösen von Partikeln aus dem Target, und zwar wird bei Verwendung von Titan als Target beim Sputtern stickstoffhaltiges Gas über das Target geleitet, dabei reagiert das Titan mit dem Stickstoff zu dem für die Pufferschicht benötigten Titannitrid.

Bei einem leitfähigen Target bietet sich das Sputtern mit Gleichspannung an (dc-Sputtern). Wenn das Target nicht leitfähig ist, kommt nur das Hochfrequenz-Sputtern in Frage (rf-Sputtern, rf: radio frequency).

Mit einem Target aus TiN bei Anwendung des (rf-)Sputterns lässt sich auf dem angeschliffenen und gereinigten Wafer eine Pufferschicht aus TiN auftragen. Statt TiN kann auch Tac oder MnO zur Herstellung der Pufferschicht verwendet werden. Das Sputtern wird vorgenommen bei einem Druck von ca. 4 · 10⁻³ mbar, bei einem Argon-Gasfluss von ca. 20 sccm (1 sccm = 1 cm³/min) und einer rf-Leistung von ca. 200 W.

Wenn die Pufferschicht eine Dicke von ca. 1 · 10⁻⁹ m bis 1 · 10⁻⁵ m erreicht hat, wird der Vorgang abgeschlossen.

Dünne Pufferschichten neigen im Falle von Temperaturänderungen weniger zum Abreissen, weil bei geringer Schichtdicke die eleastischen Konstanten günstiger sind.

Ein geringer Unterschied der Ausdehnungskoeffizienten von Pufferschicht und monokristallinem Kristall begünstigt ein fehlerfreies Kristallwachstum auf der Pufferschicht.

Anschliessend kann die Pufferschicht mit dergleichen Flüssigkeit, mit der auch der Wafer für das Sputtern vorbereitet wurde, gereinigt werden.

Danach wird durch eine Schichtabscheidung aus der Gasphase eine Schicht aus Siliziumkarbid auf der Pufferschicht aufgetragen. Dazu wird ein plasmaunterstütztes CVD-Verfahren (PECVD: plasma enhanced chemical vapour deposition) eingesetzt.

Für dieses Verfahren wird zunächst der mit der Pufferschicht versehene Wafer auf eine Temperatur von ca. 550-620 °C gebracht. Für die Schichtabscheidung wird ein Gasfluss von ca. 370 sccm Argon (Ar), 785 sccm Ethen (C₂H₄) und 40 sccm Silan (SiH₄) über den erhitzten Wafer geleitet. Damit die Gase dissoziieren und sich dadurch auf der Pufferschicht Siliziumkarbid abscheidet, werden die Gase einer rf-Leistung (rf: radio frequency) von ca. 5-20 W bei einer Frequenz von ca. 13,56 MHz und einem Druck von ca. 0,8 mbar ausgesetzt.

Anschliessend wird der Wafer mit der darauf befindlichen Pufferschicht und mit dem Siliziumkarbid in einem Ofen (Temperrohr) zur Rekristallisation bei einer Temperatur von ca. 1200 °C vier Stunden lang einer Argon-Gasströmung ausgesetzt und danach 8 Stunden lang - ebenfalls bei einer Argon-Gasströmung - bis auf 500 °C abgekühlt; bei diesem Vorgang richten sich die Zonen mit kristallinem Aufbau einheitlich aus, und es entsteht unmittelbar auf der Pufferschicht des Wafers nahezu fehlerfreies, monokristallines Siliziumkarbid.

Das so hergestellte Siliziumkarbid erstreckt sich über die gesamte Oberfläche der Pufferschicht, die ihrerseits die eine Seite des Wafers vollständig überdeckt.

Besonders günstig für eine industrielle Produktion ist eine Gasphasenepitaxie des Siliziumkarbids. Dazu wird bei einer Temperatur von ca. 1400 °C das Siliziumkarbid unmittelbar aus der Gasphase auf der Pufferschicht abgeschieden (vgl. Applied Physics Letters, Ausg. 42, Nr. 5, 1. März 1983, Seite 461). Bei der Abscheidung bildet sich direkt das monokristalline Siliziumkarbid, und es wird der oben beschriebene, eigene Verfahrensschritt des Rekristallisierens eingespart.

Anschliessend werden elektronische Bauelemente in das Siliziumkarbid integriert. Dazu werden zunächst gezielt durch Diffusion, durch epitaxiales Aufbringen oder durch Ionenimplantation p- und n-leitende Zonen erzeugt, die - gemäss dem herkömmlichen Herstellungsschritten für die Integration von Bauelementen - teilweise durch Oxidschichten gegeneinander isoliert und dann durch geätzte Metallbahnen verbunden werden. Die integrierten Schaltungen werden zum Schluss aus dem Wafer herausgeschnitten.

## Patentansprüche

1. Mehrschichtige Zusammensetzung mit einer Schicht aus monokristallinem Beta-Siliziumkarbid, mit einer einkristallinen Substratschicht und mit einer dazwischen liegenden, eine Gitteranpassung bewirkenden, dünnen Pufferschicht,
**dadurch gekennzeichnet**,
daß in der Schicht aus monokristallinem Beta-Siliziumkarbid mindestens ein elektronisches Bauteil integriert ist, daß die dünne Pufferschicht weder Siliziumkarbid noch das Material der Substratschicht, noch TiC enthält und daß das Material der Pufferschicht eine Gitterkonstante zwischen 4,2 · 10⁻¹⁰ m bis 4,5 · 10⁻¹⁰ m hat.

2. Mehrschichtige Zusammensetzung nach Anspruch 1,
**dadurch gekennzeichnet**,
daß das Siliziumkarbid als ebene Schicht vorliegt und eine Dicke von 1 · 10⁻⁶ m bis 20 · 10⁻⁶ m hat.

3. Mehrschichtige Zusammensetzung nach einem der vorangehenden Ansprüche,
**dadurch gekennzeichnet**,
daß die Pufferschicht eine Dicke von 1 · 10⁻⁹ m bis 1 · 10⁻⁵ m aufweist.

4. Mehrschichtige Zusammensetzung nach einem der vorangehenden Ansprüche,
**dadurch gekennzeichnet**,
daß die Substratschicht aus einkristallinem Silizium besteht.

5. Mehrschichtige Zusammensetzung nach einem der vorangehenden Ansprüche,
**dadurch gekennzeichnet**,
daß die Pufferschicht Tantalkarbid (TaC) enthält.

6. Mehrschichtige Zusammensetzung nach einem der vorangehenden Ansprüche,
**dadurch gekennzeichnet**,
daß die Pufferschicht Titannitrid (TiN) enthält.

7. Mehrschichtige Zusammensetzung nach einem der Ansprüche 1 bis 4,
dadurch gekennzeichnet,
daß die Pufferschicht Manganoxid (MnO) enthält.

8. Mehrschichtige Zusammensetzung nach einem der Ansprüche 5 bis 7,
**dadurch gekennzeichnet**,
daß die Pufferschicht in ihrer Zusammensetzung stöchiometrisch ist.

9. Mehrschichtige Zusammensetzung nach einem der Ansprüche 5 bis 7,
**dadurch gekennzeichnet**,
daß die Pufferschicht in ihrer Zusammensetzung leicht von der Stöchiometrie abweicht, und zwar in der Weise, daß das Verhältnis der jeweiligen zwei chemischen Elemente im Verhältnis 1:1 bis 1:0,7 bzw. bis 0,7:1 vorliegt.

10. Mehrschichtige Zusammensetzung nach einem der vorangehenden, Ansprüche
**dadurch gekennzeichnet**,
daß das Silizium an der Seite, an der sich die Pufferschicht befindet, eine im Winkel von 1° bis 10° gegenüber den Netzebenen des kristallinen Siliziums angeschliffene Oberfläche aufweist.

11. Verfahren zur Herstellung einer mehrschichtigen Zusammensetzung nach einem der vorangehenden Ansprüche,
**dadurch gekennzeichnet,**
daß zunächst das Einkristall-Substrat mit einem Winkel von 1° bis 10° gegenüber seinen Netzebenen angeschliffen wird, daß anschliessend das Einkristall-Substrat gereinigt wird, daß danach durch rf-Sputtern mit einem Target aus dem für die Pufferschicht bestimmten Material bei einer Gasströmung mit 20 sccm Argon, einem Druck von ca. 4 · 10⁻³ mbar und einer Leistung von ca. 200 W die Pufferschicht auf dem Einkristall-Substrat aufwächst, daß sie anschliessend bei einem Druck von 0,8 mbar und bei einer rf-Leistung von 5 bis 20 W einem Gasstrom mit ca. 370 sccm Argon (Ar), ca. 785 sccm Ethen (C₂H₂) und ca. 40 sccm Silan (SiH₄) zur Abscheidung von Siliziumkarbid auf der Pufferschicht ausgesetzt wird, daß danach das Siliziumkarbid bei 500-1200 °C in einer Argon-Gasströmung rekristallisiert wird und daß schliesslich elektronische Baulemente in das Siliziumkarbid integriert werden, wobei Diffusion oder Ionenimplantation zur Dotierung eingesetzt werden.

12. Verfahren zur Herstellung einer mehrschichtigen Zusammensetzung nach Anspruch 11,
**dadurch gekennzeichnet**,
daß das Einkristall-Substrat vor dem Auftragen einer Pufferschicht in einer Lösung mit ca. 525 ml H₂O, mit ca. 150 ml H₂O₂ und mit ca. 75 ml NH₃ bei einer Temperatur von ca. 90 °C gereinigt wird.

13. Verfahren zur Herstellung einer mehrschichtigen Zusammensetzung nach Anspruch 11 oder 12,
**dadurch gekennzeichnet**,
daß die Zusammensetzung nach dem Aufbringen des Siliziumkarbids rekristallisiert wird, indem sie zunächst vier Stunden lang einer Argon-Gasströmung bei einer Temperatur von ca. 1200 °C ausgesetzt und anschliessend 8 Stunden lang bis auf 500 °C abgekühlt wird.

14. Verfahren zur Herstellung einer mehrschichtigen Zusammensetzung nach einem der Ansprüche 11 bis 13,
**dadurch gekennzeichnet**,
daß statt einer Dotierung durch Ionenimplantation oder durch Diffusion während des rf-Sputterns eine Dotierung mit Fremdstoffen durch Gasphasenepitaxie vorgenommen wird.

## Claims

1. Multilayer composition with a layer of monocrystalline beta-silicon carbide, with a monocrystalline substrate layer and with a thin buffer layer lying therebetween and effecting a lattice matching, characterised thereby, that at least one electronic component is integrated in the layer of monocrystalline beta-silicon carbide, that the thin buffer layer contains neither silicon carbide nor the material of the substrate layer nor TiC and that the material of the buffer layer has a lattice constant between 4.2 . 10⁻¹⁰ to 4.5 . 10⁻¹⁰.

2. Multilayer composition according to claim 1, characterised thereby, that the silicon carbide is present as planar layer and has a thickness of 1 . 10⁻⁶ to 20 . 10⁻⁶.

3. Multilayer composition according to one of the preceding claims, characterised thereby, that the buffer layer displays a thickness of 1 . 10⁻⁹ to 1 . 10⁻⁵.

4. Multilayer composition according to one of the preceding claims, characterised thereby, that the substrate layer consists of monocrystalline silicon.

5. Multilayer composition according to one of the preceding claims, characterised thereby, that the buffer layer contains tantalum carbide (TaC).

6. Multilayer composition according to one of the preceding claims, characterised thereby, that the buffer layer contains titanium nitride (TiN).

7. Multilayer composition according to one of the claims 1 to 4, characterised thereby, that the buffer layer contains manganese oxide (MnO).

8. Multilayer composition according to one of the claims 5 to 7, characterised thereby, that the buffer layer is stoichiometric in its composition.

9. Multilayer composition according to one of the claims 5 to 7, characterised thereby, that the buffer layer departs slightly from stoichiometry in its composition and namely in such a manner that the ratio of the respective two chemical elements is from 0.7:1 to 1:1.

10. Multilayer composition according to one of the preceding claims, characterised thereby, that the silicon displays a surface, which is ground at an angle of 1° to 10° to the lattice plane of the crystalline silicon at the side at which the buffer layer is disposed.

11. Method for the manufacture of a multilayer composition according to one of the preceding claims, characterised thereby, that the monocrystalline substrate is ground initially at an angle of 1° to 10° relative to its lattice planes, that the monocrystalline substrate is subsequently cleaned, that the buffer layer thereafter grows on the monocrystalline substrate by rf-sputtering with a target of the material intended for the buffer layer with a gas flow of 20 cubic centimetres per minute of argon at a pressure of about 4 . 10⁻³ millibars and with a power of about 200 watts, that it subsequently exposed, at a pressure of 0.8 millibars and with an rf-power of 5 to 20 watts, to a gas flow of about 370 cubic centimetres per minute of argon (Ar), about 785 cubic centimetres per minute of ethane (C₂H₂) and about 40 cubic centimetres per minute of silane (SiH₄) for the precipitation of silicon carbide onto the buffer layer, that the silicon carbide is thereafter recrystallised at 500 to 1200°C in an argon gas flow and that electronic components are finally integrated into the silicon carbide, wherein diffusion or ion implantation are used for doping.

12. Method for the manufacture of a multilayer composition according to claim 11, characterised thereby, that the monocrystalline substrate is cleaned, before the application of a buffer layer, in a solution of about 525 millilitres of H₂O, of about 150 millilitres of H₂O₂ and about 75 millilitres of NH₃ at a temperature of 90°C.

13. Method for the manufacture of a multilayer composition according to claim 11 or 12, characterised thereby, that the composition is recrystallised after the application of the silicon carbide in that it is initially exposed for four hours to an argon gas flow at a temperature of about 1200°C and subsequently cooled for 8 hours to 500°C.

14. Method for the manufacture of a multilayer composition according to one of the claims 11 to 13, characterised thereby, that a doping by foreign substances by gas phase epitaxy is undertaken during the rf-sputtering in place of a doping by ion implantation or by diffusion.

## Revendications

1. Composition multicouches comprenant une couche en carbure de silicium bêta monocristallin, une couche de substrat monocristallin et, entre ces dernières, une mince couche tampon provoquant une adaptation de réseau, caractérisée en ce qu'au moins un élément électronique est intégré dans la couche en carbure de silicium bêta monocristallin, en ce que la mince couche tampon ne contient ni du carbure de silicium, ni la matière de la couche de substrat et ni du TiC, et en ce que la matière de la couche tampon présente une constante de réseau entre 4,2 . 10⁻¹⁰ m et 4,5 . 10⁻¹⁰ m.

2. Composition multicouches selon la revendication 1,
caractérisée en ce que
le carbure de silicium se présente sous la forme d'une couche plane dont l'épaisseur est de l'ordre de 1 . 10⁻⁶ m à 20 . 10⁻⁶ m.

3. Composition multicouches selon l'une des revendications précédentes,
caractérisée en ce que
la couche tampon présente une épaisseur de 1 . 10⁻⁹ m à 1 . 10⁻⁵ m.

4. Composition multicouches selon l'une des revendications précédentes,
caractérisée en ce que
la couche de substrat se compose de silicium monocristallin.

5. Composition multicouches selon l'une des revendications précédentes,
caractérisée en ce que
la couche tampon contient du carbure de tantale (TaC).

6. Composition multicouches selon l'une des revendications précédentes,
caractérisée en ce que
la couche tampon contient du nitrure de titane (TiN)

7. Composition multicouches selon l'une des revendications 1 à 4,
caractérisée en ce que la couche tampon contient de l'oxyde de manganèse (MnO).

8. Composition multicouches selon l'une des revendications 5 à 7,
caractérisée en ce que la couche tampon est de composition stoechiométrique.

9. Composition multicouches selon l'une des revendications 5 à 7,
caractérisée en ce que la couche tampon présente une composition qui diffère légèrement de la stoechiométrie et, ce, de manière que le rapport des deux éléments chimiques considérés soit de l'ordre de 1:1 à 1:0,7 à 0,7:1.

10. Composition multicouches selon l'une des revendications précédentes,
caractérisée en ce que
le silicium comprend, sur la face présentant la couche tampon, une surface polie suivant un angle de 1° à 10° par rapport aux plans de réseau du silicium cristallin.

11. Procédé pour la fabrication d'une composition multicouche selon l'une des revendications précédentes,
caractérisé en ce que
tout d'abord le substrat monocristallin est poli suivant un angle de 1° à 10° par rapport à ses plans de réseau, en ce qu'ensuite, le substrat monocristallin est nettoyé, en ce qu'après cela, par pulvérisation R.F. avec une cible en matière destinée à la couche tampon en présence d'un courant de gaz de 20 sccm d'argon, d' une pression d'environ 4 . 10⁻³ mbar et d'une puissance d'environ 200 W, la couche tampon se développe sur le substrat monocristallin, en ce qu'ensuite, à une pression de 0,8 mbar et une puissance R.F. de 5 à 20 W, la couche est exposée à un courant de gaz d'environ 370 sccm d'argon (Ar), environ 785 sccm d'éthène (C₂H₂) et environ 40 sccm Silan (SiH₄) pour le dépôt de carbure de silicium sur la couche tampon, en ce qu'ensuite le carbure de silicium est recristallisé à 500-1200 °C dans un courant de gaz d'argon et en ce que, pour finir, les éléments électroniques sont intégrés dans le carbure de silicium, la diffusion ou l'implantation ionique étant utilisées pour le dopage.

12. Procédé pour la fabrication d'une composition multicouche selon la revendication 11,
caractérisé en ce que
le substrat monocristallin est nettoyé, avant l'application sur une couche tampon, dans une solution avec environ 525 ml H₂O, avec environ 150 ml H₂O₂ et avec environ 75 ml NH₃ à une température d'environ 90°C.

13. Procédé pour la fabrication d'une composition multicouche selon la revendication 11 ou 12,
caractérisé en ce que
la composition est recristallisée après l'application du carbure de silicium, en étant tout d'abord exposée pendant quatre heures à un courant de gaz d'argon à une température d'environ 1200°C et, pour finir, en étant refroidie pendant 8 heures à 500° C.

14. Procédé pour la fabrication d'une composition multicouche selon l'une des revendications 11 à 13,
caractérisé en ce que
au lieu d'un dopage par implantation ionique ou par diffusion pendant la pulvérisation R.F., il est effectué un dopage avec des matières étrangères par épitaxie en phase gazeuse.
